# EUROPÄISCHE PATENTSCHRIFT

(11) **EP 2 707 897 B1**
(45) Veröffentlichungstag und Bekanntmachung des Hinweises auf die Patenterteilung: **19.09.2018**
(21) Anmeldenummer: 12727271.4
(22) Anmeldetag: 08.05.2012
(51) Int. Cl.: H01L 23/26, H01L 23/10, H01L 23/055, H05K 5/06

(54) **STEUERGERÄT MIT EINER GETTERSCHICHT ZUM EINSATZ IN EINEM KRAFTFAHRZEUG**
CONTROL DEVICE WITH A GETTER LAYER FOR USE IN A MOTOR VEHICLE
APPAREIL DE COMMANDE COMPRENANT UNE COUCHE GETTER À UTILISER DANS UN VÉHICULE AUTOMOBILE

(30) Priorität: 09.05.2011 DE 102011100977; 21.12.2011 DE 102011056742
(43) Veröffentlichungstag der Anmeldung: 19.03.2014
(73) Patentinhaber: Conti Temic Microelectronic GmbH, 90411 Nürnberg (DE)
(72) Erfinder: HENNIGER, Jürgen, 91056 Erlangen-Dechsendorf (DE); WIECZOREK, Matthias, 91233 Neunkirchen am Sand (DE); URBANEK, Thomas, 91126 Schwabach (DE); GEBHARDT, Marion, 91322 Gräfenberg (DE); SCHUCH, Bernhard, 91616 Neusitz (DE); REIF, Andreas, 90552 Röthenbach (DE); GOTTSCHLING, Stefan, 90542 Eckenthal (DE)
(74) Vertreter: Bonn, Roman Klemens
(86) Internationale Anmeldenummer: PCT/DE2012/100131
(87) Internationale Veröffentlichungsnummer: WO 2012/152271

(56) Entgegenhaltungen:
- EP-A2- 2 308 797
- DE-A1- 3 913 066
- FR-A1- 2 883 099
- US-A1- 2008 283 989
- US-B1- 6 423 575

## Beschreibung

Die Erfindung betrifft ein Steuergerät 1 nach dem Oberbegriff des Anspruchs 1.

Im Kraftfahrzeugbau ist es seit längerer Zeit üblich, Steuergeräte für Motor oder Getriebe in die zu steuernde Kraftfahrzeugbaugruppe, also Motor oder Getriebe, zu integrieren. Vor allem die Getriebesteuergeräte bilden als so genannte Vorortsteuergerät eine äußerst kompakte Einheit. Im Vergleich zur konventionellen Verwendung externer Anbausteuergeräte hat diese Anordnung enorme Vorteile im Bezug auf Qualität, Kosten, Gewicht und Funktionalität. Insbesondere resultiert daraus eine erhebliche Verringerung von unter Umständen fehleranfälligen Steckverbindungen und Leitungen.

Die Integration des Steuergerätes in das Getriebe stellt hohe Anforderungen an seine thermische und mechanische Belastbarkeit. Die Funktionalität muss sowohl über einen breiten Temperaturbereich (etwa -40°C bis hin zu 200°C) als auch bei mechanischen Vibrationen (bis zu etwa 40g) gewährleistet sein. Da das Steuergerät von aggressiven Medien wie Getriebeöl umgeben ist, muss es zudem öldicht ausgeführt sein.

In Vor-Ort-Getriebesteuergeräten kann es dennoch durch das unerwünschte Eindringen zum Beispiel von schwefelhaltigen Schadgasen durch Diffusion von außen durch die Dichtungen in den Schaltungsträgerinnenraum des Steuergerätegehäuses oder durch Ausgasen z.B. von Dichtungsmaterialien, Gehäuse oder Kunststoffe im Schaltungsträgerinnenraum zur Schädigung der elektronischen Funktionskomponenten wie Mikrokontroller oder auch zur Schädigung von Bondpads oder Bonddrähten kommen. Dies kann unter Umständen zum Totalausfall der Steuergeräte weit vor deren prognostizierter Lebenserwartung führen.

Kommen insbesondere metallhaltige Bauteile im Innenraum von GetriebeSteuergeräten mit korrosiven Medien, wie schwefelhaltigen Gasen, Wasser oder feuchter Luft in Kontakt, so greifen diese das Metall an und es korrodiert. Dabei reagiert insbesondere der im Wasser gelöste Sauerstoff mit dem Metall. Dem Metall werden Elektronen entzogen und die positiv geladenen Ionen können in Lösung gehen.

Eine Möglichkeit, um dies zu verhindern ist der so genannte kathodische Korrosionsschutz. Dabei wird eine so genannte Opferanode mit dem zu schützenden Metall leitend verbunden. Das zu schützende Metall ist die Kathode und das unedlere Metall ist die Opferanode. Es ergibt sich ein Stromfluss in Richtung des zu schützenden Metalls. Nun werden dem unedleren Metall seine Elektronen entzogen. Der Transport der geladenen Teilchen geschieht über den direkten Kontakt der beiden Metalle oder durch Wasser oder Wasserdampf als Elektrolyt.

Diese Methode zum Verhindern der Korrosion metallhaltiger Bauteile im Innenraum von GetriebeSteuergeräten ist hier nicht anwendbar, da dies zu undefinierten Kriechströmen oder sogar zu Kurzschlüssen führen würde.

Eine andere Möglichkeit zum Verhindern derartiger Korrosion wird in der DE 34 42 132 C2 beschrieben. In einem Gehäuse ist ein verkapseltes Mikroelektronikelement von Silikonkautschuk umgeben, in dem ein Gettermaterial als feinst- körniges, eine Barium-Aluminium-Legierung enthaltendes Pulver dispergiert ist. Dieses Pulver ist aber nur bedingt dafür geeignet, insbesondere aggressive gasförmige Bestandteile wie zum Beispiel Schwefel, zu binden. Vielmehr hat sich herausgestellt, dass Silikonkautschuk insbesondere für schwefelhaltige Gase eine Schwammwirkung aufweist, und damit Korrosion noch verstärkt.

Eine weitere Möglichkeit, eine derartige Korrosion zu verhindern, wird in der DE 39 13 066 A1 beschrieben. Dabei ist in dem Deckel eines Gehäuses für Elektronikkomponenten eine Aussparung zur Aufnahme von Gettermaterial ausgebildet. Das Gettermaterial ist durch eine Folie abgedeckt und fixiert. Die Folie wird unmittelbar vor dem Zusammenbau des Gehäuses perforiert, damit das Gettermaterial seine Funktion erfüllen kann. Diese Methode zur Verhinderung von Korrosion ist sehr aufwändig.

Weitere Dokumente, die Getter enthalten, sind US 6 423 575 B1, EP 2 308 797 A2, US 2008/0283989 A1 und FR 2 883 099 A1.

Es ist daher die Aufgabe der vorliegenden Erfindung, ein Steuergerät 1 der eingangs genannten Art derart weiterzubilden, dass die Getterfunktion, insbesondere zum Gettern von schwefelhaltigen Gasen, verbessert wird.

Diese Aufgabe ist erfindungsgemäß gelöst durch eine Warnvorrichtung mit den Merkmalen des Anspruchs 1.

Erfindungsgemäß wurde erkannt, dass in einem Steuergerät, das insbesondere als GetriebeSteuergerät vor Ort im Getriebe eines Kraftfahrzeugs eingesetzt wird, die Korrosion der metallenen, strom- oder datenübertragenden Bestandteile im Inneren des Steuergeräts, wie zum Beispiel Leiterahnen, Bondpads oder Bonddrähten durch aggressive. Gase, vor allem durch schwefelhaltige Gase, verhindert oder zumindest verzögert wird, indem auf der Innenfläche des Gehäuses eine Getterschicht zum Absorbieren dieser aggressiven Schadgase aufgebracht wird. Eine thermisch aufgespritzte Getterschicht weist im Vergleich mit zum Beispiel galvanisch oder mittels CVD aufgetragenen Getterschichten eine besonders hohe spezifische Oberfläche und damit ein besonders hohes Absorptionsvermögen auf.

Insbesondere ist die Getterschicht auf der Innenfläche des Gehäusedeckels derart selektiv aufgebracht, dass die Kontaktfläche des Gehäusedeckels zum Gehäuseboden nicht mit einer Getterschicht überzogen wird. Dadurch wird verhindert, dass durch eine sonst eventuell eintretende Veränderung der Kontaktoberfläche des Gehäusedeckels zum Gehäuseboden, hervorgerufen durch die Reaktion der Getterschicht mit den Schadgasen, das Gehäuse an dieser Stelle undicht wird.

Die Getterschicht ist aus einem Metall wie Aluminium, Kupfer, Silber, Stahl oder einer Silber-Palladium-Legierung, wobei diese Schichten relativ einfach und kostengünstig herzustellen sind.

Wenn die Leiterstruktur als eine flexible Leiterfolie mit jeweils an den Enden angeordneten offenen Kontaktbereichen ausgeführt ist, ist die Layout-Gestaltung der Verbindung zwischen den elektronischen Bauteilen im Inneren das Steuergerätes und Komponenten außerhalb des Steuergeräts, wie z. B. Sensoren oder Aktoren einfacher und platzsparender als mit einer starren Leiterplatte, wobei die offenen Kontaktbereichen der Leiterfolie zumindest im Inneren des Steuergeräts als Bondpads ausgebildet sind...

Ein elektronisches Bauteil, insbesondere ein ungehäuster mikroelektronischer Baustein, auch Bare Die genannt, auf dem Schaltungsträger ist mittels einer Verbindungsleitung mit den offenen Kontaktbereichen oder Bonpads der Leiterfolie elektrisch leitend verbunden. Diese Verbindungsleitung ist in der Regel ein Bonddraht aus hochleitfähigem Metall wie zum Beispiel Aluminium oder Gold, was eine bewährt zuverlässige elektrische Verbindung darstellt.

Als zusätzlicher Schutz vor korrosiven Gasen können der Schaltungsträger und die Verbindungsleitung mit einer weichen Kunststoffschicht umgeben sein. Dies bietet auch einen Schutz gegen Lösen von Bauteilen z. B. von dem Schaltungsträger bei extremen Vibrationsbelastungen.

Weitere Merkmale, Vorteile und Einzelheiten der Erfindung sind der nachfolgenden Beschreibung entnehmbar, in der ein bevorzugtes Ausführungsbeispiel anhand der beigefügten Zeichnungen näher erläutert wird. Diese zeigen:
Fig. 1 einen Schnitt durch ein Steuergerät 1 und
Fig. 2 eine Draufsicht auf die Gehäusebodeninnenseite.

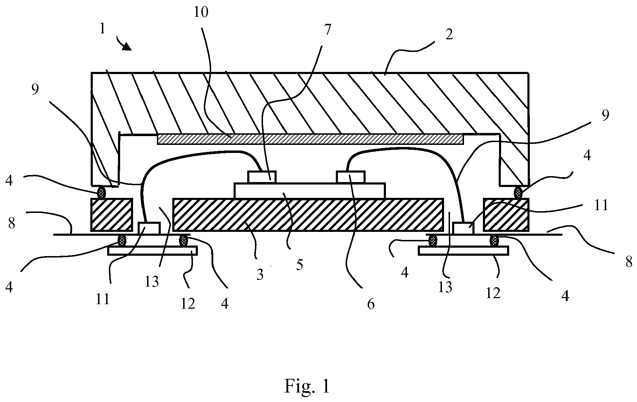

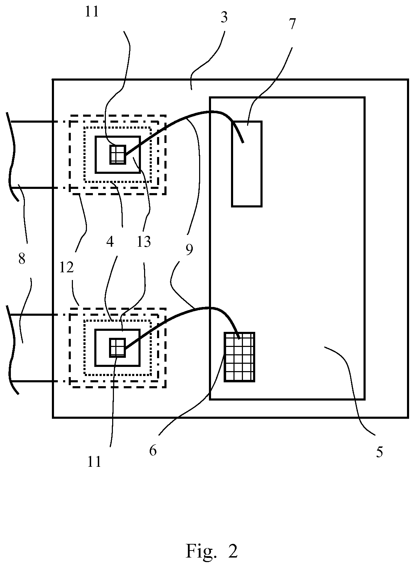

Gemäß Fig. 1 umfasst ein Steuergerät 1 für ein Kraftfahrzeug einen Gehäuseboden 3 und eine Gehäusedeckel 2. Der Gehäuseboden 3 und die Gehäusedeckel 2 bilden einen Innenraum, in dem sich ein Schaltungsträger 5 befindet. Der Schaltungsträger 5 ist auf dem Gehäuseboden 3 insbesondere mit einem elektrisch isolierenden Wärmeleitkleber aufgeklebt. Ist der Gehäuseboden 3 zum Beispiel aus einem metallischen Werkstoff, so wird die auf dem Schaltungsträger 5 entstehende Wärme besonders gut an die an den Gehäuseboden 3 angrenzende Umgebung abgeleitet. Auf dem Schaltungsträger 5 sind mindestens ein elektronisches Bauteil 6, 7 angeordnet. Der Gehäuseboden 3 weist in dem den Schaltungsträger 5 umlaufend umgebenden Bereich, benachbart zu einem elektronischen Bauteil 6, 7 einen Durchbruch 13 auf. Zur Veranschaulichung sei in diesem Zusammenhang auch auf die Fig. 2 verwiesen. Am Durchbruch 13 ist auf der Außenseite des Gehäusebodens 3, also die dem Schaltungsträger abgewandten Seite des Gehäusebodens 3 , eine Leiterstruktur 8, vorzugsweise als flexibler Folienleiter, kurz Flexfolienleiter ausgebildet, angebracht. Der Flexfolienleiter ist beispielsweise eine Polyimid-Folie mit einer Vielzahl von elektrisch leitenden, jedoch jeweils voneinander isolierten Leiterbahnen.

Am Endabschnitt des Flexfolienleiters 8 im Inneren des Steuergerätes ist ein Kontaktbereich 11 angeordnet. Der Flexfolienleiter 8 ist so über dem Durchbruch 13 platziert, dass er mit seinem Endabschnitt 10 den Durchbruch 13 vollständig überdeckt und dass sich der elektrische Kontaktbereich 11 vollständig im Durchbruch 13 befindet, also nicht mit dem Gehäuseboden 3 in Kontakt kommt. Andernfalls wäre die Gefahr eines Kurzschlusses gegeben. Der elektrische Kontaktbereich 11 auf dem Flexfolienleiter 8 im Durchbruch 13 ist wiederum über die Leiterbahnen im Flexfolienleiter 8 in nicht gezeigter Weise mit elektronischen und/oder elektrischen Bauteilen, wie Sensoren oder Aktoren , außerhalb des Steuergerätes elektrisch verbunden. Die elektrischen Verbindungsleitungen 9, in der Regel sind dies Bonddrähte aus hochleitfähigem Metall wie Aluminium oder Gold, wiederum stellen den elektrischen Kontakt zwischen den elektrischen Bauteilen 6, 7 oder den Leiterbahnen auf dem Schaltungsträger 5 mit den entsprechenden elektrischen Kontaktbereichen 11 im Durchbruch 13 her. Die Deckelplatte 12 überdeckt den Durchbruch 13 vollständig und bewirkt, dass der Flexfolienleiter 8 öldicht mit dem Gehäuseboden 3 verbunden ist. Die Ankopplung der Deckelplatte 12 an den Gehäuseboden 3 kann durch eine kraft- oder formschlüssige Verbindung wie Verschrauben oder Verstemmen hergestellt werden.

Wie in Fig. 1 gezeigt liegt zwischen dem Flexfolienleiter 8 und der Deckelplatte 12 eine den Durchbruch 13 umlaufende Dichtung 4, um eine zusätzliche Sicherheit bezüglich Öldichtheit zu gewährleisten. Die Dichtung 4 kann der Einfachheit halber an die Deckelplatte 12 angespritzt sein.

Der Gehäuseboden 3 ist über eine Dichtung 4 öldicht an den Gehäusedeckel 2 gekoppelt. Insbesondere in Vor-Ort-Getriebesteuergeräten kann es dennoch aufgrund der extremen äußeren Bedingungen durch das unerwünschte Eindringen zum Beispiel von schwefelhaltigen Schadgasen aus dem Getriebeöl in den Innenraum des Gehäuses 1 zur Korrosion der metallenen, strom- oder datenübertragenden Bestandteile im Inneren des Steuergeräts, wie zum Beispiel der elektronischen Bauteile 6, 7 wie Mikrokontroller, der Leiterahnen auf dem Schaltungsträger 5, von offenen Kontakflächen 11 auf den Flexfolienleitern 8 oder Bonddrähten 9 kommen. Dies kann unter Umständen zum Totalausfall des Steuergeräts weit vor deren prognostizierter Lebenserwartung führen.
Fig.1 zeigt auf der Innenfläche des Gehäusedeckels 2 eine Getterschicht 10. Insbesondere ist die Getterschicht 10 auf die Innenfläche des Gehäusedeckels 2 aufgespritzt. Als besonders geeignet hat sich eine thermisch aufgespritzte Getterschicht 10, z. B. mittels Kaltgasspritzen, erwiesen, da eine so aufgebrachte Getterschicht 10 im Vergleich mit zum Beispiel galvanisch oder mittels CVD aufgetragenen Getterschichten eine besonders hohe spezifische Oberfläche und damit ein besonders hohes Gasabsorptionsvermögen aufweist. Dadurch kann die Korrosion durch die Schadgase entweder ganz verhindert oder zumindest verzögert werden. Diese Getterschicht 10 besteht insbesondere aus einem Metall wie Aluminium, Kupfer, Silber, Silber-Palladium-Legierung oder Stahl. Somit besteht die Getterschicht 10 im wesentlichen aus demselben Material wie die zu schützenden Bestandteile 5, 6, 7, 8, 9, 11 im Innenraum des Gehäuses 1. Ausschlaggebend dabei ist, dass die Getterschicht 10 eine um ein Vielfaches höhere spezifische Oberfläch aufweist, als die Oberfläche der zu schützenden Bestandteile 5, 6, 7, 8, 9, 11 zusammen. Die Getterschicht 10, die in der Lage ist, die Schadgase irreversibel zu absorbieren, ist aufgrund der Auftragungsart an die Kontur der Innenfläche des Gehäusedeckels 2 angepasst. Die Getterwirkung der Getterschicht 10 ist umso größer, je näher sie an den zu schützenden Bestandteile 5, 6, 7, 8, 9, 11 angeordnet ist.

Insbesondere ist die Getterschicht 10 auf der Innenfläche des Gehäusedeckels 2 derart selektiv aufgebracht, dass die Kontaktfläche des Gehäusedeckels 2 zum Gehäuseboden 3 nicht mit einer Getterschicht 10 überzogen ist. Dadurch wird verhindert, dass durch eine sonst eventuell eintretende Veränderung der Kontaktoberfläche des Gehäusedeckels 2 zum Gehäuseboden 3, hervorgerufen durch die Reaktion der Getterschicht 10 mit den Schadgasen, das Gehäuse 1 an dieser Stelle undicht wird.

Um zu verhindern, dass die am Gehäusedeckel 2 aufgebrachte Getterschicht 10 bereits vor dem Zusammenbau des Gehäuses 1 mit der Umgebung reagiert, wird der Gehäusedeckel 2 mit der Getterschicht 10 vorzugsweise entweder in einer Schutzgasatmosphäre gelagert oder die Getterschicht 10 wird erst kurz vor dem Zusammenbau des Gehäuses aufgespritzt.

Fig. 2 zeigt eine Draufsicht auf die Innenseite des Gehäusebodens 3 und dient lediglich zur Veranschaulichung der Anordnung im Bereich eines Durchbruchs 13. Der elektrische Kontaktbereich 11 auf dem Flexfolienleiter 8 ist so im Durchbruch 13 angeordnet, dass er mit dem Gehäuseboden 3 nicht in Berührung kommt, also keinen Kurzschluss über den meist metallischen Gehäuseboden 3 verursachen kann . Um den Durchbruch 13 verläuft die Dichtung 4 zwischen dem Flexfolienleiter 8 und der Deckelplatte 12.

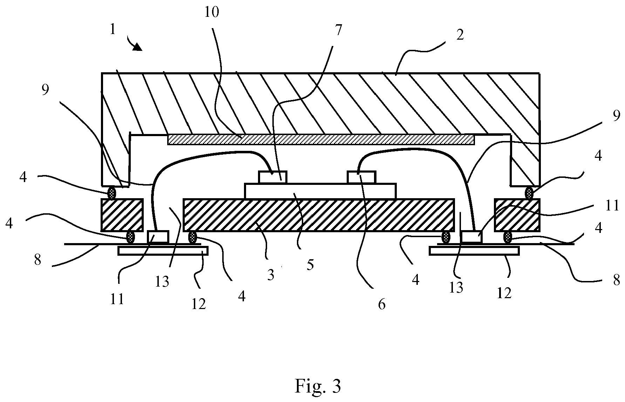

Die Dichtung 4 kann aber auch zwischen dem Flexfolienleiter 8 und dem Gehäuseboden 3 angeordnet sein, wie ein Fig. 3 gezeigt.

Die vorliegende Erfindung wurde anhand der vorstehenden Beschreibung so dargestellt, um das Prinzip der Erfindung und dessen praktische Anwendung bestmöglich zu erklären.

## Patentansprüche

1. Steuergerät in einem Kraftfahrzeug, mit
- einem Gehäuse (1) aus einem Gehäusedeckel (2) und einem Gehäuseboden (3),
- einer Dichtvorrichtung (4) zwischen Gehäusedeckel (2) und Gehäuseboden (3),
- mindestens einem Schaltungsträger (5) mit elektrisch leitenden Leiterbahnen, wobei auf dem Schaltungsträger (5) mindestens ein elektronisches Bauteil (6, 7) angeordnet ist,
- mindestens eine Leiterstruktur (8), die aus dem Inneren des Gehäuses (1) herausführt,
- mindestens eine elektrisch leitende Verbindungsleitung (9), die das elektronische Bauteil (6, 7) mit der Leiterstruktur (8) verbindet,
**dadurch gekennzeichnet, dass**
auf der Innenfläche des Gehäuses (1) eine Getterschicht (10) zum Schutz der metallenen, strom- oder datenübertragenden Bestandteile (5, 6, 7, 8, 9, 11) im Inneren des Steuergeräts vor schwefelhaltigen Gasen thermisch aufgespritzt ist, wobei die Getterschicht (10) im Vergleich mit galvanisch aufgetragenen Getterschichten eine besonders hohe spezifische Oberfläche aufweist und, dass die Getterschicht (10) aus einem der Metalle Aluminium, Kupfer, Silber, Silber-Palladium-Legierung oder Stahl ist.

2. Steuergerät nach Anspruch1, **dadurch gekennzeichnet, dass** die Getterschicht (10) auf der Innenfläche des Gehäuses (1) selektiv aufgebracht ist.

3. Steuergerät nach Anspruch 2, **dadurch gekennzeichnet, dass** die Getterschicht (10) auf der Innenfläche des Gehäusesdeckels (2) derart selektiv aufgebracht ist, dass die Kontaktfläche des Gehäusedeckels (2) zum Gehäuseboden (3) frei von einer Getterschicht (10) ist.

4. Steuergerät nach einem der vorangehenden Ansprüche , **dadurch gekennzeichnet, dass** die Leiterstruktur (8) ein Flexfolienleiter mit jeweils am Endabschnitt angeordneten offenen Kontaktbereichen (11) ist.

5. Steuergerät nach Anspruch 4 , **dadurch gekennzeichnet, dass** die offenen Kontaktbereiche (11) der Leiterstruktur (8) zumindest im Inneren des Steuergeräts als Bondpads ausgebildet sind.

6. Steuergerät nach einem der vorangehenden Ansprüche , **dadurch gekennzeichnet, dass** die Verbindungsleitung (9) ein Bonddraht aus hochleitfähigem Metall wie zum Beispiel Aluminium oder Gold ist.

7. Steuergerät nach einem der vorangehenden Ansprüche , **dadurch gekennzeichnet, dass** das elektronische Bauteil (6, 7) ein ungehäuster mikroelektronischer Baustein ist.

8. Steuergerät nach einem der vorangehenden Ansprüche , **dadurch gekennzeichnet, dass** der Schaltungsträger (5) und die Verbindungsleitung (9) mit einer weichen Kunststoffschicht als zusätzlicher Schutz vor korrosiven Gasen umgeben ist.

## Claims

1. Control unit in a motor vehicle, comprising
- a housing (1) composed of a housing cover (2) and a housing base (3),
- a sealing device (4) between housing cover (2) and housing base (3),
- at least one circuit carrier (5), having electrically conductive conductor tracks, wherein at least one electronic component (6, 7) is arranged on the circuit carrier (5),
- at least one conductor structure (8) which leads out from the interior of the housing (1),
- at least one electrically conductive connection line (9) which connects the electronic component (6, 7) to the conductor structure (8),
**characterized in that**
a getter layer (10) for protecting the metallic, current- or data-transmitting constituents (5, 6, 7, 8, 9, 11) in the interior of the control unit against sulphur-containing gases is thermally sprayed on the inner surface of the housing (1), wherein the getter layer (10) has a particularly high specific surface area in comparison with galvanically applied getter layers, and wherein the getter layer (10) is composed of one of the metals aluminium, copper, silver, silver-palladium alloy or steel.

2. Control unit according to Claim 1, **characterized in that** the getter layer (10) is selectively applied on the inner surface of the housing (1).

3. Control unit according to Claim 2, **characterized in that** the getter layer (10) is selectively applied on the inner surface of the housing cover (2) in such a way that the contact area of the housing cover (2) with respect to the housing base (3) is free of a getter layer (10).

4. Control unit according to any of the preceding claims, **characterized in that** the conductor structure (8) is a flexible film conductor having open contact regions (11) arranged in each case at the end section.

5. Control unit according to Claim 4, **characterized in that** the open contact regions (11) of the conductor structure (8) at least in the interior of the control unit are configured as bond pads.

6. Control unit according to any of the preceding claims, **characterized in that** the connection line (9) is a bond wire composed of highly conductive metal such as aluminium or gold, for example.

7. Control unit according to any of the preceding claims, **characterized in that** the electronic component (6, 7) is an unpackaged microelectronic module.

8. Control unit according to any of the preceding claims, **characterized in that** the circuit carrier (5) and the connection line (9) are surrounded with a soft plastics layer as additional protection against corrosive gasses.

## Revendications

1. Appareil de commande dans un véhicule automobile, avec
- un boîtier (1) composé d'un couvercle de boîtier (2) et d'un fond de boîtier (3),
- un dispositif d'étanchéité (4) entre le couvercle de boîtier (2) et le fond de boîtier (3),
- au moins un support de circuits (5) avec des pistes de conducteurs électriquement conductrices, dans lequel au moins un composant électronique (6, 7) est disposé sur le support de circuits (5),
- au moins une structure conductrice (8), qui conduit hors de l'intérieur du boîtier (1),
- au moins une ligne de raccordement électriquement conductrice (9), qui relie le composant électronique (6, 7) à la structure conductrice (8),
**caractérisé en ce que**
une couche de piégeage (10) est pulvérisée à chaud sur la face intérieure du boîtier (1) pour protéger les composants métalliques (5, 6, 7, 8, 9, 11), qui transmettent du courant et des données, à l'intérieur de l'appareil de commande contre des gaz sulfurés, dans lequel la couche de piégeage (11) présente une surface spécifique particulièrement élevée par comparaison avec des couches de piégeage déposées électriquement, et la couche de piégeage (10) se compose d'un des métaux aluminium, cuivre, argent, alliage argent-palladium ou acier.

2. Appareil de commande selon la revendication 1, **caractérisé en ce que** la couche de piégeage (10) est déposée de façon sélective sur la face intérieure du boîtier (1).

3. Appareil de commande selon la revendication 2, **caractérisé en ce que** la couche de piégeage (10) est déposée de façon sélective sur la face intérieure du couvercle de boîtier (2), de telle manière que la face de contact du couvercle de boîtier (2) avec le fond de boîtier (3) soit dépourvue d'une couche de piégeage (10).

4. Appareil de commande selon l'une quelconque des revendications précédentes, **caractérisé en ce que** la structure conductrice (8) est un conducteur plat flexible avec des zones de contact ouvertes (11) disposées respectivement à la partie d'extrémité.

5. Appareil de commande selon la revendication 4, **caractérisé en ce que** les zones de contact ouvertes (11) de la structure conductrice (8) sont formées par des plots de soudage au moins à l'intérieur de l'appareil de commande.

6. Appareil de commande selon l'une quelconque des revendications précédentes, **caractérisé en ce que** la ligne de raccordement (9) est un fil de connexion en métal hautement conducteur comme par exemple l'aluminium ou l'or.

7. Appareil de commande selon l'une quelconque des revendications précédentes, **caractérisé en ce que** le composant électronique (6, 7) est un composant microélectronique nu.

8. Appareil de commande selon l'une quelconque des revendications précédentes, **caractérisé en ce que** le support de circuits (5) et la ligne de raccordement (9) sont enveloppés par une couche de matière plastique souple comme protection supplémentaire contre des gaz corrosifs.
